# EUROPÄISCHE PATENTANMELDUNG

(11) **EP 1 703 551 A1**
(43) Veröffentlichungstag der Anmeldung: **20.09.2006**
(21) Anmeldenummer: 06005284.2
(22) Anmeldetag: 15.03.2006
(51) Int. Cl.: H01L 21/306, H01L 21/00, B08B 3/12

(54) **Verfahren sowie Vorrichtung zum Behandeln von Gegenständen, insbesondere zum Reinigen von Halbleiterelementen**

(30) Priorität: 15.03.2005 DE 102005012244
(71) Anmelder: Rena Sondermaschinen GmbH, 78148 Gütenbach (DE)
(72) Erfinder: Löhmann, Mirko, 78120 Furtwangen (DE); Herter, Richard, 79211 Denzlingen (DE); Bürger, Norbert, 79199 Kirchzarten (DE)
(74) Vertreter: Stürken, Joachim

(57) **Zusammenfassung**

Die Erfindung bezieht sich auf das kontinuierliche Reinigen von Gegenständen, insbesondere von Halbleiterelementen, mit Ultraschall, wobei die zu reinigenden Gegenstände in einer Flüssigkeit angeordnet sind. Ferner betrifft die vorliegende Erfindung eine Vorrichtung zur Durchführung des erfindungsgemäßen Verfahrens.

Ein erfindungswesentlicher Gedanke der Erfindung ist, dass die Oberfläche eines zu reinigenden Gegenstandes (2) in einem mit Fluid gefüllten Becken (5) mindestens ein Schwingungsmaximum erfährt, das von mindestens einer im Becken (5) vorgesehenen Schallquelle (8a) ausgesendet wird. Eine Ausführung sieht dabei vor, die in dem Becken (5) angeordneten Schallquellenfelder (8) schräg zur Ebene der Transportrichtung (4) anzuordnen.

## Beschreibung

### Technisches Gebiet

Die Erfindung bezieht sich auf das Reinigen von Gegenständen, insbesondere von Halbleiterelementen, mit Ultraschall, wobei die zu reinigenden Gegenstände in einer Flüssigkeit angeordnet sind. Ferner betrifft die vorliegende Erfindung eine Vorrichtung zur Durchführung des erfindungsgemäßen Verfahrens.

### Hintergrund der Erfindung

Die Reinigung mittels Ultraschallwellen ist im Allgemeinen bekannt. Die Ultraschallreinigung wird überwiegend in der industriellen Teilefertigung angewendet und insbesondere in der Elektrotechnik, in der Feinwerkmechanik, bei der Metallverarbeitung oder auch bei der Leiterplattenfertigung eingesetzt. Weitere typische Anwendungsbereiche für diese Art von Objektreinigung finden sich in der Fotoindustrie sowie in der Medizintechnik. Die Verwendung von Ultraschallwellen dient dazu, insbesondere auf Gegenständen befindliche Schmutzpartikel zu entfernen, und bietet sich an, wenn die Verunreinigungen mit mechanischen Reinigungsgeräten wie beispielsweise Bürsten oder Poliermitteln nur unzureichend erreicht und abgelöst werden können.

Für die Ultraschallreinigung nach den im Stand der Technik bekannten wie auch nach dem erfindungsgemäßen Verfahren ist es notwendig, dass der zu reinigende Gegenstand in einer Flüssigkeit angeordnet ist, so dass die von einem Ultraschallgenerator über geeignete Ultraschallschwinger ausgesendeten Schallwellen über das flüssige Medium auf den zu reinigenden Gegenstand übertragen werden können. Sogenannte Schallquellenfelder entsenden den Schall, der auf den zu reinigenden Gegenstand trifft.

Insbesondere während eines Halbleiterfertigungsprozesses sind unterschiedliche Reinigungsschritte notwendig, um Schmutzpartikel und auch die durch die Bearbeitung entstehenden Teilchen von den Halbleitern, beispielsweise Wafern oder Scheiben, zu entfernen. Diese Teilchen, die insbesondere bei der mechanischen Bearbeitung der Halbleiterelemente (Substrate) wie z.B. beim Sägen entstehen, können Sägepartikel sein, die aus dem Material des Substrats bestehen. Auch wird häufig eine so genannte "Slurry" oder Schmirgelpulver-Emulsion eingesetzt. Diese Slurry umfasst Siliziumkarbid oder Aluminiumoxid in einer Glykol oder Öl enthaltenden Mischung. Diese Verunreinigungen (Teilchen, Partikel, Reste organischer Verbindungen etc.) müssen in einem oder mehreren Reinigungsschritten entfernt werden, damit die gewünschten Produkteigenschaften sichergestellt werden können.

Aus dem Stand der Technik sind Verfahren bekannt, bei dem die zu reinigenden Gegenstände wie beispielsweise Wafer oder Scheiben zunächst in Trageeinrichtungen einsortiert werden. Entweder per Hand oder automatisch werden diese anschließend in Becken mit einer entsprechenden Flüssigkeit getaucht, wobei die Trageeinrichtungen stationär fixiert oder, alternativ, entweder mit einer Handhabungseinrichtung oder manuell innerhalb des Reinigungsbeckens bewegt werden.

Um ein besseres Reinigungsergebnis zu erzielen, werden zumeist mehrere unterschiedliche Becken bereitgestellt, wie z.B. 10 bis 20 Becken, die unterschiedliche Flüssigkeiten und/oder unterschiedliche Schallquellen aufweisen. Die Schallquellen selbst senden mit unterschiedlichen Frequenzen, so dass in den einzelnen Becken unterschiedliche Reinigungsergebnisse erzielt werden können.

Zur Unterstützung der Reinigungswirkung werden die Becken meistens warm betrieben, wobei gewöhnlich eine Temperatur zwischen 30°C und 60°C eingestellt wird. Die Frequenzen liegen im Ultraschallbereich und werden von Schallquellen ausgesendet, die in der Regel am Boden als auch teilweise an den Wänden der Reinigungsbecken angeordnet sind. Alternativ oder zusätzlich werden so genannte Tauchschwinger verwendet, die bevorzugt an denjenigen Stellen im Reinigungsbecken platziert werden, von denen man sich die Realisierung einer möglichst gleichmäßigen Verteilung der Schallwellen im Reinigungsbad erhofft. Nach einer im Stand der Technik bevorzugten Variante sind der bzw. die Tauchschwinger als Plattenschwinger ausgebildet und werden zumeist unter den zu reinigenden Objekten platziert. Die Plattenschwinger werden in der Regel bei großflächigen Teilen eingesetzt, um zu gewährleisten, dass die Schallwellen auch das ganze Objekt erreichen.

Die typische Gesamtdauer eines solchen Reinigungsprozesses inklusive Trocknung beträgt circa eine Stunde und erfordert zumeist mehrere manuelle oder maschinell unterstützte Umsetzvorgänge, wodurch sich relativ hohe Bruchraten einstellen. Insbesondere im Zusammenhang mit der Bearbeitung zukünftiger Wafer mit einer Kantenlänge von 200 mm und einer Dicke von unter 200 µm besteht daher ein Bedarf an alternativen Reinigungsverfahren, mit denen die zu reinigenden Gegenstände schneller, günstiger und schonender behandelt werden können.

Aus der US-B 4 979 994 sind Verfahren und Vorrichtung zur Reinigung von Leiterplatinen bekannt. Dabei wird die Leiterplatine in einer Flüssigkeit mit Schall bearbeitet. Damit auch Reinigung in dem Raum stattfindet, der zwischen den elektrischen Bauelementen und der Leiterplatine angeordnet ist, werden Schallquellenfelder schräg und zwar in einem Winkel zwischen -60 und +60 Grad zur Senkrechten zur Leiterplatine ausgerichtet. Durch Reflexion sollen dann diese so ausgebildeten Hinterschneidungen erreicht werden. Das jeweilige Schallquellenfeld und die beschallte Leiterplatine bleiben zueinander stationär.

Aus der DE-C 1 078 406 ist eine Einrichtung zum Reinigen von Metallen mittels Ultraschall bekannt. Die Einrichtung besteht aus einer rotierenden Trommel, die trichterförmig ausgebildet ist. Stationär ist ein Schallquellenfeld angeordnet, dessen Position entlang der Mantelfläche der Trommel positionierbar ist.

Aus der DE 192 22 423 C2 ist eine Vorrichtung zum Behandeln von Substraten, insbesondere Halbleiter-Wafern bekannt. Diese Substrate werden in einem Fluidbecken auf einem Trägerelement, das stegartig ausgebildet ist, gelagert. Um eine größere Reinigungsausbeute zu erzielen, kann das Trägerelement zusammen mit dem Substrat angehoben und gesenkt werden, so dass zwischen Schallquellenfeld und Substrat wahlweise ein größerer oder kleinerer Abstand entsteht.

### Aufgabe der Erfindung

Die Aufgabe der vorliegenden Erfindung besteht darin, ein Verfahren und/oder eine Vorrichtung vorzuschlagen, mit der insbesondere bruchempfindliche Gegenstände mittels Schall gereinigt werden können.

### Lösung der Aufgabe

Ein wesentlicher Gedanke der Erfindung besteht darin, dass ein Verfahren sowie eine Vorrichtung vorgeschlagen werden, durch deren Ausgestaltung sichergestellt ist, dass die Oberfläche eines zu reinigenden Gegenstandes in einem Reinigungsbecken mindestens ein Schwingungsmaximum erfährt, das von mindestens einer im Becken anwesenden Schallquelle ausgesendet wird. Dieses Schwingungsmaximum entspricht dem so genannten "Schwingungsbauch"

Demgemäß werden zur Lösung der Aufgabe ein Verfahren gemäß Anspruch 1 und/oder eine Vorrichtung gemäß Anspruch 2 vorgeschlagen.

Erfindungsgemäß kann die Realisierung der Aufgabenlösung mit unterschiedlichen Mitteln erfolgen, wie nachfolgend ausgeführt wird. Gemeinsames Merkmal dieser alternativen Ausführungsformen ist, dass am zu reinigenden Gegenstand ein jeweiliges Schwingungsmaximum mit maximaler Amplitude auftrifft. Hierzu muss der mechanische Abstand zwischen einer Schallquelle und dem zu bearbeitenden Gegenstand vorzugsweise auf wenige Millimeter genau eingestellt werden können. Diese gegenüber dem Stand der Technik optimierte Einkopplung des Ultraschalls in die Flüssigkeit des Reinigungsbeckens ist bei allen Ausführungsformen gleichermaßen sichergestellt.

Die typischen Wellenlängen λ von Ultraschall in Flüssigkeit betragen zwischen 10mm und 80mm, wobei die Frequenzen 20kHz bis 132kHz betragen und die Flüssigkeit Wasser ist (Beispiel: bei einer Frequenz von 25kHz beträgt die Wellenlänge im Wasser circa 59mm).

Vorzugsweise sind die Schallquellen als so genannte Schallquellenfelder organisiert. Mit dem Begriff Schallquellenfelder werden nachfolgend solche Anordnungen bezeichnet, die aus mehreren Schwingungsquellen bestehen, welche zumindest für sich gesehen phasengleich abstrahlen. Insbesondere können solche Schallquellenfelder Plattenschwinger mit ebenen Flächen sein.

Neben der Beseitigung der vorstehend beschriebenen Nachteile des Standes der Technik besteht ein wesentlicher Vorteil der Erfindung nach einer bevorzugten Ausführungsform darin, dass die Reinigung von Gegenständen kontinuierlich durchgeführt werden kann, ohne dass eine manuelle oder maschinell unterstützte Umlagerung oder Umsortierung erfolgen muss.

Erfindungsgemäß wird dies vorteilhafterweise dadurch erreicht, dass der zu reinigende Gegenstand mittels einer Transporteinrichtung durch eine Flüssigkeit hindurch transportiert wird. Ein Beispiel für ein derartiges Transportsystem ist in WO 2003/086913 A1 offenbart. Während seines Transportes wird der Gegenstand an einer Abfolge unterschiedlich eingestellter Schallquellen vorbeigeführt, wobei diese Schallquellen innerhalb der Reinigungsflüssigkeit angeordnet sind und Frequenzen im Ultraschallbereich aussenden. Durch die in den alternativen Ausführungsformen realisierte exakte räumliche Beziehung zwischen einem Schallquellenfeld und der Oberfläche des zu reinigenden Gegenstandes wird sichergestellt, dass die Schallwellen mit ihren Schwingungsmaxima auf den zu reinigenden Gegenstand auftreffen. Dies kann direkt oder indirekt erfolgen, wie nachstehend ausgeführt wird.

Mechanisch ist es möglich, ein Schallquellenfeld innerhalb eines mit Flüssigkeit gefüllten Beckens im definierten Abstand relativ zum reinigenden Gegenstand anzuordnen.

Die Zusammensetzung und die Temperatur der Flüssigkeit sowie andere Einbauten, die innerhalb des Beckens vorgesehen sind, als auch mögliche Reflektionen an den zu reinigenden Gegenständen, führen jedoch gewöhnlich zu Differenzen, durch die ein gegebener Schwingungsbauch verschoben wird, so dass trotz optimaler mechanischer Voraussetzung die Gefahr besteht, dass nicht sicher minimal ein Schwingungsbauch einer Schallwelle mit maximaler Amplitude auf den zu reinigenden Gegenstand auftrifft.

Der erfindungswesentliche Gedanke besteht nun nach einem ersten Aspekt darin, dass die einzelnen Schallquellenfelder, an denen der zu reinigende Gegenstand vorzugsweise über die Transporteinrichtung vorbeigeführt wird, nicht parallel zur Transportrichtung angeordnet ist, sondern schräg. Schräg bedeutet in diesem Fall, dass das Schallquellenfeld mit seiner Oberfläche nicht parallel zur Ebene ausgerichtet ist, die durch den zu reinigenden Gegenstand gebildet wird, sondern dass zwischen der Ebene des Schallquellenfelds und der Ebene des zu reinigenden Gegenstands eine definierte Neigung vorliegt. Die Neigung ist dabei von der Transportrichtung unabhängig. Dies bedeutet, dass die Neigung in Transportrichtung erfolgen kann, d.h. der Abstand des Schallquellenfelds zur Ebene des zu transportierenden Gegenstands wird größer oder umgekehrt.

In einer weiterführenden Ausbildung wird erfindungsgemäß vorgeschlagen, dass während des Transports des Gegenstandes durch das Becken vorgesehen ist, mehr als ein Schallquellenfeld anzuordnen. Dabei kann vorgesehen sein, diese mit unterschiedlichen Frequenzen anzusteuern. Vorzugsweise sind die einzelnen mit gleicher Frequenz angesteuerten Schallquellenfelder durch Beckenbegrenzungen voneinander getrennt. Zu Beginn des ersten Reinigungsschrittes wird vorgeschlagen, mit einer tiefen Frequenz (z.B. 25 kHz) zu beginnen, um grobe und größere Partikel zu entfernen. In Transportrichtung werden in Abhängigkeit der konkreten Aufgabenstellung bevorzugt schrittweise höhere Frequenzen (z.B. 40 kHz und höher) eingesetzt, so dass kontinuierlich zuerst grobe Partikel im Anfangsbereich bis zu sehr feinen Partikeln im Endbereich sukzessive entfernt werden. Diese Frequenzen können bis zum Megaschallbereich geführt werden, wobei der Megaschallbereich Frequenzen von 800kHz bis zu 2MHz nutzt. Dabei können die Neigungen der einzelnen Schallquellenfelder sowie deren Abstand zur Ebene des Transports des zu reinigenden Gegenstands unterschiedlich sein.

Um ein gutes Reinigungsergebnis zu erzielen und die Aufgabe zu lösen, dass auf dem am Schallquellenfeld vorbei geführten Gegenstand mindestens ein Schwingungsmaximum auftrifft, wird erfindungsgemäß vorgeschlagen, die Neigung des Schallquellenfelds zur Ebene des Transports des Gegenstands deutlich kleiner als λ/2 auszuführen, wobei λ die Wellenlänge ist, mit der das Schallquellenfeld emittiert. Es hat sich gezeigt, dass es vorteilhaft ist, den theoretischen Ort des Schwingungsbauches über der Mitte des Schwingungsfeldes einzustellen und das gesamte Schallquellenfeld um einen Wert von deutlich kleiner als λ/2 zu kippen. Ein besonders effektives Reinigungsergebnis wird erzielt, wenn die Neigung des Schallquellenfeldes relativ zur Ebene des zu transportierenden Gegenstands λ/4 oder sogar λ/8 beträgt. Alternativ kann die Schrägstellung des Schallquellenfeldes bei paralleler Anordnung desselben durch Bereitstellung einer ggf. fokussierenden Reflexionsfläche erfolgen, die zwischen dem Feld und dem zu bearbeitenden Gegenstand derart angeordnet ist, dass die Schallwellen die oben dargelegte Ausbreitungscharakteristik aufweisen. Eine weitere Alternative dieser Ausführungsform besteht darin, dass die zu reinigenden Gegenstände bei horizontaler Anordnung der Schallquellenfelder zumindest vorübergehend aus ihrer waagerechten Position in eine Schrägstellung überführt werden.

Eine weitere Ausführungsform besteht darin, die schräg gestellten Schallquellenfelder parallel zur Transportebene zumindest teilweise zu führen und damit relativ zur Transportrichtung zu bewegen.

Nach einem weiteren Aspekt der vorliegenden Erfindung kann der oben dargelegte erfinderische Grundgedanke auch durch eine horizontale Anordnung der Schallquellenfelder parallel zur Transportebene realisiert werden, sofern die Schallquellenfelder bewegbar ausgestaltet sind und eine Relativbewegung zum Gegenstand ermöglichen. Die Möglichkeit der Veränderung der Position eines horizontal angeordneten Schallquellenfeldes in Beziehung zum Reinigungsobjekt sorgt in der Praxis dafür, dass der Schwingungsbauch einer Schallwelle im Verlauf der Bewegung mindestens einmal mit maximaler Amplitude auf den zu bearbeitenden Gegenstand auftrifft.

Nach einer bevorzugten Ausführungsform sind die Schallquellenfelder daher bewegbar und parallel zur Transportrichtung der zu reinigenden Gegenstände angeordnet, wobei die Bewegung vertikal (senkrecht) zur Transportrichtung erfolgt.

Um eine homogenere Reinigung zu erzielen, kann nach einer weiteren Ausführungsform vorteilhafterweise vorgesehen sein, dass die Bewegung vertikal (senkrecht) und horizontal (parallel) zur Transportrichtung erfolgt, wobei die vertikale und horizontale Bewegung nacheinander oder gleichzeitig ausgeführt werden kann.

Eine weitere Ausführungsform besteht darin, eine Kombination aus den vorgenannten Ausführungsformen bereitzustellen. Dies bedeutet, dass eine dreidimensionale Bewegung der Schallquellenfelder erfolgt. Eine bevorzugte Kombination sieht beispielsweise vor, dass die Schallquellenfelder bewegbar und schräg zur Transportrichtung der zu reinigenden Gegenstände angeordnet sind, wobei die Bewegung entweder vertikal oder vertikal und horizontal zur Transportrichtung erfolgt. Auch durch diese kombinatorische Verfahrensweise wird gewährleistet, dass mindestens ein Schwingungsmaximum auf den zu reinigenden Gegenstand auftrifft.

Bei der bereits genannten erfindungsgemäßen Ausführung, bei der die Schallquellenfelder relativ zu dem zu reinigenden Gegenstand parallel zur Transportrichtung oder -ebene bewegt werden, ist es von Vorteil, wenn die Relativbewegung langsam ausgeführt wird, damit ein möglichst stabiles Schallfeld aufgebaut wird. Die typische hier vorliegende Amplitude senkrecht zur Transportrichtung ist deutlich kleiner als λ/2, wobei λ die emittierende Wellenlänge der Schallquellenfelder ist. Ein besonders bevorzugtes Ausführungsbeispiel sieht vor, dass die Amplitude senkrecht zur Transportrichtung λ/4 beträgt. Diese Amplitude muss während des Aufenthalts eines zu reinigenden Gegenstands im Becken mindestens einmal durchlaufen werden.

Nach einer Ausführungsform der vorliegenden Erfindung werden die Gegenstände auf ein Transportsystem, wie z.B. ein Rollentransportsystem gelegt. Hierbei werden die Gegenstände mit Hilfe von mehreren hintereinander angeordneten und waagerecht ausgerichteten Transportrollen transportiert. Die einzelnen Transportrollen sind in einem Fluid vorzugsweise derart angeordnet, dass sich die jeweils obere Kante der Rollen ungefähr auf der Höhe der Fluidoberfläche, d.h. des oberen Flüssigkeitsrandes des Fluids, befindet, so dass die Unterseite des jeweiligen Gegenstands durch direkten Kontakt mit der Fluidoberfläche benetzt wird. Hierbei kann sich ein Meniskus an den Gegenstandkanten bilden. Ein Zusammenspiel aus Schwerkraft und Oberflächenspannung zieht dann der Gegenstand nach unten und sorgt dafür, dass es in Kontakt mit den Rollen bleibt, ohne aufzuschwimmen. Dadurch ist ein kontrollierter und definierter Transport der Gegenstände mit dem Rollentransportsystem möglich.

Nach einer besonders bevorzugten Ausführungsform befinden sich auf der Transportrolle mindestens zwei Auflageelemente, die vorteilhafterweise auf der Transportrolle im Bereich zweier Nuten angeordnet sein können. Der Abstand zwischen den Auflageelementen wird durch die Breite der zu behandelnden Gegenstands vorgegeben. Im Bereich des Schallquellenfelds wird angestrebt, dem zu reinigenden Gegenstand ausreichend Freiheit zu geben. Daher sind gerade in diesem Bereich Führungselemente weiter beabstandet und die den Transportrollen gegenüber angeordneten und den zu reinigenden Gegenstand zwischen sich einschließenden Niederhalter weisen größere Bewegungsmöglichkeiten auf, so dass eventuell auftretende Kräfte von dem Gegenstand abgeleitet werden können. Damit wird das Ziel erreicht, so wenig wie möglich Kraft auf das zu reinigende Gut auszuüben. Die Bruchrate wird dadurch erheblich gemindert.

Die Transportrolle ist vorzugsweise mindestens zweiteilig aufgebaut und besteht aus einem Achselement und mindestens einem das Achselement umgebenden Spurelement. Die Achselemente der einzelnen Transportrollen sind im Bereich der Schallquellenfelder weiter voneinander beabstandet, damit der von den Schallquellenfelder ausgesandte Schall besser auf den zu reinigenden Gegenstand treffen kann. Die Achsen bestehen aus einem Material, das den Schall nur gering in seiner Ausbreitung behindert.

Nach einem weiteren Aspekt der vorliegenden Erfindung wird eine Vorrichtung zur Durchführung des erfindungsgemäßen Verfahrens bereitgestellt. Die wesentlichen Merkmale dieser Vorrichtung ergeben sich aus den obigen Angaben zur Verfahrenssteuerung und sind in Anspruch 2 zusammengefasst.

Die Durchführung des erfindungsgemäßen Verfahrens liefert neben den bereits erwähnten Vorteilen eine im Vergleich zu bekannten Verfahren deutliche Reduzierung der Prozessdauer. Es konnte gezeigt werden, dass die übliche Verfahrensdauer von etwa einer Stunde erfindungsgemäß auf ca. 10 Minuten verkürzt werden kann.

Ein weiterer wesentlicher Vorteil der Erfindung besteht darin, dass bei den erfindungsgemäßen Verfahren auf die übliche Verwendung von Chemikalien im Reinigungsbad verzichtet werden kann. Ferner ermöglicht die Erfindung, die Temperatur der Reinigungsflüssigkeit auf Raumtemperatur, d.h. auf einen Wert zwischen ca. 15°C und ca. 25°C einzustellen, ohne dass eine Verschlechterung des erfindungsgemäß erzielten hervorragenden Reinigungsergebnisses befürchtet werden müsste.

Eine Alternative kann darin bestehen, als reinigendes Medium teilentsalztes oder deionisiertes Wasser zu verwenden.

In diesem Zusammenhang wird jedoch ausdrücklich darauf hingewiesen, dass die Anwendung herkömmlicher Temperaturen und/oder die Verwendung chemischer Agenzien in der Reinigungsflüssigkeit natürlich erfindungsgemäß eingeschlossen sind.

Weitere Vorteile ergeben sich aus der nachfolgenden Beschreibung, den Zeichnungen sowie den Ansprüchen.

### Zeichnungen

- Fig. 1: zeigt eine schematische Darstellung einer Vorrichtung zum Reinigen von Gegenständen, insbesondere von Halbleiterelementen in der Ausbildung von Wafern beziehungsweise Scheiben zur Durchführung des erfindungsgemäßen Verfahrens,
- Fig. 2: zeigt eine Teildarstellung der Fig. 1, die zur Verdeutlichung des Transports des zu reinigenden Gegenstands dient.

### Beschreibung eines Ausführungsbeispiels

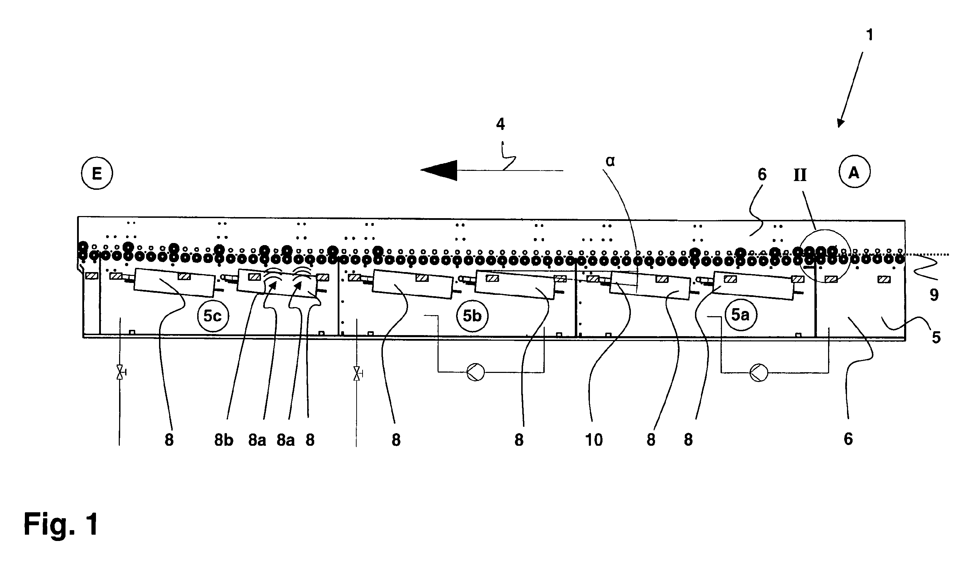

In Fig. 1 ist schematisch eine erfindungsgemäße Vorrichtung 1 zum Reinigen von Gegenständen 2, insbesondere von Wafern in der Ausbildung von Scheiben, dargestellt.

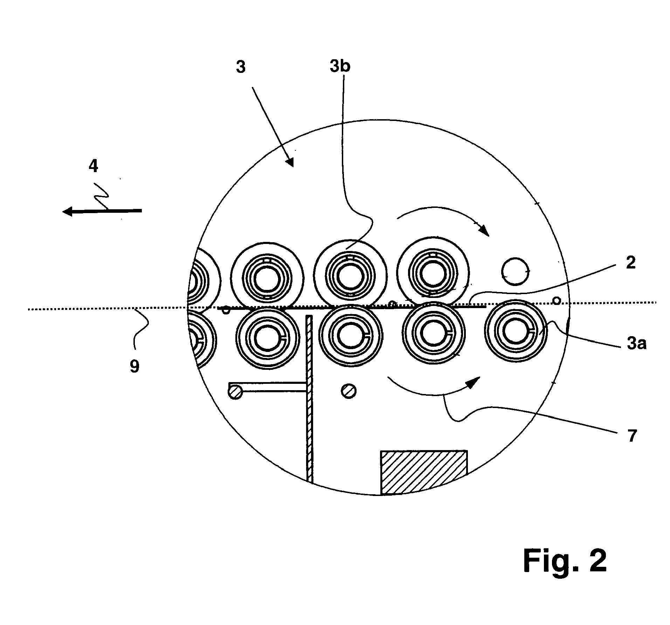

Die Gegenstände 2 werden durch die Transporteinrichtung 3 in Transportrichtung 4 durch ein Becken 5 bewegt. Das Becken 5 ist mit einer Flüssigkeit 6 gefüllt. Die Transporteinrichtung 3 selbst besteht bevorzugt aus Antriebsrollen 3a und Niederhaltern 3b (Fig. 2), wobei die Antriebsrollen 3a aufgrund ihrer Drehbewegung in Pfeilrichtung 7 für den Antrieb der Gegenstände 2 in Transportrichtung 4 sorgen. Die Niederhalter 3b, die in gegenläufiger Richtung (gegen Pfeilrichtung 7) drehen, dienen dazu, dass die Gegenstände 2 nicht in der Flüssigkeit 6 aufschwimmen.

Das Becken 5 ist in unterschiedliche Bereiche, in sogenannte Segmente 5a, 5b, 5c unterteilt. Alle Segmente 5a, 5b, 5c können fluidmäßig miteinander verbunden sein und werden über die Transporteinrichtung 3 bedient. Innerhalb eines jeden Segmentes 5a, 5b, 5c ist bei dem hier dargestellten Ausführungsbeispiel mindestens ein Schallquellenfeld 8 angeordnet. Dieses Schallquellenfeld 8 sendet von seiner Schallquelle 8a Schall 8b in Richtung der jeweiligen über dem Schallquellenfeld angeordneten Gegenstände 2. Aufgrund der die jeweiligen Schallquellenfelder 8 umgebenen Flüssigkeit 6 wird der von dem Schallquellenfeld 8 erzeugte Schall in die Flüssigkeit eingekoppelt und auf den Gegenstand 2 übertragen.

In einem anderen nicht näher dargestellten Ausführungsbeispiel können auch eine oder mehrere Schallquellenfelder 8 innerhalb der Segmente angeordnet sein.

Die Segmente 5a, 5b, 5c sind weder für die Durchführung des erfindungsgemäßen Verfahrens noch für die Vorrichtung zwingend erforderlich. Sie dienen lediglich dazu, die einzelnen Bereiche einfacher definieren zu können und unterschiedliche Reinigungsbereiche festzulegen. Auch die Anzahl der dargestellten Segmente sind erfindungsgemäß nicht festgelegt und können unter Berücksichtigung der konkreten Anforderungen frei gewählt werden.

Innerhalb der Segmente 5a, 5b, 5c sind die Schallquellenfelder 8 derart angeordnet, dass sie nicht parallel zur Transportrichtung 4 ausgerichtet sind, sondern eine Neigung aufweisen. Dies bedeutet, dass sie gegenüber der Transportrichtung 4 schräg angeordnet sind, wobei die schräge Anordnung grundsätzlich in beide Richtungen (mit bzw. entgegen der Transportrichtung) ausgebildet sein kann. Aufgrund dieser schrägen Anordnung ergibt sich zwischen der horizontalen Ebene 9 in Transportrichtung 4 und der Ebene 10, die von dem jeweiligen Schallquellenfeld 8 aufgespannt wird, ein Winkel α. Diese definierte Neigung ist vorzugsweise kleiner als λ/2, wobei λ die Wellenlänge ist, in der das Schallquellenfeld 8 den erzeugten Schall emittiert.

In dem vorliegenden Ausführungsbeispiel ist das Schallquellenfeld 8 innerhalb der jeweiligen Segmente 5a, 5b, 5c starr angeordnet.

### Verfahrensweise

Die einzelnen Gegenstände 2, hier beispielsweise eben bzw. flach ausgebildete Wafer werden an einem ersten Sektor A in die Transporteinrichtung 3 eingegeben (oder aus einem anderen Bearbeitungsprozess übergeben) und mittels der Transporteinrichtung 3 (Transportrollen 3a sowie Niederhalter 3b) in Transportrichtung 4 bewegt. Nach einer entsprechenden Anlaufphase gelangt der zu reinigende Gegenstand 2 in einen ersten Sektor 5a und überfährt ein erstes Schallquellenfeld 8. Während des Überfahrens trifft aufgrund der erfindungsgemäßen Anordnung des Schallquellenfeldes 8 mindestens ein Schwingungsbauch mit maximaler Amplitude auf die Oberfläche des Gegenstandes. Kontinuierlich wird der Gegenstand 2 von diesem Segment 5a in das weitere Segment 5b usw. überführt. Der Vorgang wiederholt sich über jedem Schallquellenfeld 8.

Bei dem hier dargestellten Verfahren sowie bei der hier dargestellten Vorrichtung 1 sind die einzelnen Schallquellenfelder 8 in einzelne Segmente 5a, 5b, 5c untergebracht und vorzugsweise derart ausgestaltet, dass die Frequenz mit zunehmender Wegstrecke innerhalb der erfindungsgemäßen Vorrichtung stufenweise oder linear von einem Schallquellenfeld 8 zum anderen zunimmt. An dem Ende E der erfindungsgemäßen Vorrichtung kann der jeweilige gereinigte Gegenstand, der im kontinuierlichen Prozess bearbeitet worden ist, entnommen oder an eine weitere Einrichtung gegeben werden.

### Bezugszeichenliste

- 1: Vorrichtung
- 2: Gegenstände (Wafer)
- 3: Transporteinrichtung
3a Transportrolle
3b Niederhalter
- 4: Transportrichtung
- 5: Becken
5a Segment
5b Segment
5c Segment
- 6: Flüssigkeit
- 7: Pfeil (Rotationsrichtung)
- 8: Schallquellenfeld
8a Schallquelle
8b Schall
- 9: Ebene (Transportebene, Ebene der Transportrichtung 4)
- 10: Ebene (des Schallquellenfeldes 8)

- A: Anfang
- E: Ende
- α: Winkel
- λ: Wellenlänge

## Patentansprüche

1. verfahren zum Behandeln von Gegenständen, insbesondere zum Reinigen von Halbleiterelementen, in einem Becken (5), das mit Flüssigkeit (6) und Schallquellenfeldern versehen ist, wobei die Gegenstände (2) auf einer Transporteinrichtung (3) kontinuierlich durch das Becken (5) transportiert werden und die Schallquellenfelder (8), die Schall (8b) in die Flüssigkeit (6) einkoppeln, wahlweise eine der nachstehenden Positionen einnehmen:
I. Anordnung der Schallquellenfelder (8) stationär und schräg ausgerichtet zur Ebene (9) der Transportrichtung (4) der zu reinigenden Gegenstände (2); oder
II. Anordnung der Schallquellenfelder (8) bewegbar und schräg ausgerichtet zur Ebene (9) der Transportrichtung (4) der zu reinigenden Gegenstände (2), wobei die Bewegung parallel zur Transportrichtung (4) erfolgt; oder
III. Anordnung der Schallquellenfelder (8) bewegbar und parallel ausgerichtet zur Ebene (9) der Transportrichtung (4) der zu reinigenden Gegenstände (2), wobei die Bewegung vertikal zur Transportrichtung (4) erfolgt; oder
IV. Anordnung der Schallquellenfelder (8) bewegbar und parallel ausgerichtet zur Ebene (9) der Transportrichtung (4) der zu reinigenden Gegenstände (2), wobei die Bewegung vertikal und horizontal zur Transportrichtung (4) erfolgt; oder
V. Anordnung der Schallquellenfelder (8) bewegbar und schräg ausgerichtet zur Ebene (9) der Transportrichtung (4) der zu reinigenden Gegenstände (2), wobei die Bewegung entweder vertikal oder vertikal und horizontal zur Transportrichtung (4) erfolgt.

2. Vorrichtung zum Behandeln und Reinigen von Gegenständen (2), insbesondere zum Reinigen von Halbleiterelementen, in einem Becken (5), das mit Flüssigkeit (6) und Schallquellenfeldern versehen ist, wobei die Gegenstände (2) auf einer Transporteinrichtung (3) kontinuierlich durch das Becken (5) transportiert werden und die Schallquellenfelder (8), die Schall (8b) in die Flüssigkeit (6) einkoppeln, wahlweise eine der nachstehenden Positionen einnehmen:
I. Anordnung der Schallquellenfelder (8) stationär und schräg ausgerichtet zur Ebene (9) der Transportrichtung (4) der zu reinigenden Gegenstände (2); oder
II. Anordnung der Schallquellenfelder (8) bewegbar und schräg ausgerichtet zur Ebene (9) der Transportrichtung (4) der zu reinigenden Gegenstände (2), wobei die Bewegung parallel zur Transportrichtung (4) erfolgt; oder
III. Anordnung der Schallquellenfelder (8) bewegbar und parallel ausgerichtet zur Transportrichtung (4) der zu reinigenden Gegenstände (2), wobei die Bewegung vertikal zur Ebene (9) der Transportrichtung (4) erfolgt; oder
IV. Anordnung der Schallquellenfelder (8) bewegbar und parallel ausgerichtet zur Transportrichtung (4) der zu reinigenden Gegenstände (2), wobei die Bewegung vertikal und horizontal zur Ebene (9) der Transportrichtung (4) erfolgt; oder
V. Anordnung der Schallquellenfelder (8) bewegbar und schräg ausgerichtet zur Transportrichtung (4) der zu reinigenden Gegenstände (2), wobei die Bewegung entweder vertikal oder vertikal und horizontal zur Ebene (9) der Transportrichtung (4) erfolgt.

3. Vorrichtung nach Anspruch 2, **dadurch gekennzeichnet, dass** die Schallquellenfelder (8) derart relativ zu den zu reinigenden Gegenständen (2) angeordnet sind, dass der von den Schallquellenfeldern (8) erzeugte Schall (8b) mit seinen Schwingungsmaxima auf den Gegenstand (2) auftrifft.

4. Vorrichtung nach Anspruch 3, **dadurch gekennzeichnet, dass** die Schallquellenfelder (8) deutlich kleiner als λ/2 schräg gestellt sind, wobei λ die Wellenlänge des auszusendenden Schalls (8b) bezeichnet.

5. Vorrichtung nach mindestens einem der Ansprüche 2 bis 4, **dadurch gekennzeichnet, dass** die Schallquellenfelder (8) mit unterschiedlichen Frequenzen senden.

6. Vorrichtung nach Anspruch 5, **dadurch gekennzeichnet, dass** die von den Schallquellenfeldern (8) ausgesendeten Frequenzen in Transportrichtung (Pfeil 4) höher werden.

7. Vorrichtung nach mindestens einem der Ansprüche 2 bis 6, **dadurch gekennzeichnet, dass** die Transporteinrichtung (3) zur Aufnahme der Gegenstände (2) Transportelemente umfasst, die sich quer zur Transportrichtung (4) erstrecken und in einem Abstand zueinander angeordnet sind

8. Vorrichtung nach mindestens einem der Ansprüche 2 bis 7,
**dadurch gekennzeichnet, dass** die Schallquellenfelder (8) sequentiell in Transportrichtung (4) hintereinander angeordnet sind.

9. Vorrichtung nach Anspruch 8, **dadurch gekennzeichnet, dass** die Schallquellenfelder (8) dieselbe Neigung α zur Ebene der Transportrichtung (4) aufweisen.

10. Vorrichtung nach Anspruch 8, **dadurch gekennzeichnet, dass** die Schallquellenfelder (8) unterschiedliche Neigungen α zur Ebene der Transportrichtung (4) aufweisen.

11. Vorrichtung nach mindestens einem der Ansprüche 2 bis 10, **dadurch gekennzeichnet, dass** die Temperatur der Flüssigkeit (6) innerhalb des Behälters auf Raumtemperatur eingestellt wird.

12. Vorrichtung nach Anspruch 11, **dadurch gekennzeichnet, dass** die Temperatur der Flüssigkeit (6) auf einen Wert zwischen 15°C und 25°C eingestellt wird.

13. Vorrichtung nach mindestens einem der Ansprüche 1 bis 12, **dadurch gekennzeichnet, dass** die Transportelemente Transportrollen umfassen, die zum Transportieren des zu reinigenden Gegenstands (2) im Bereich der Schallquellenfelder (8) im Vergleich zur übrigen Transporteinrichtung (2) weiter voneinander beabstandet sind.

14. Vorrichtung nach mindestens einem der Ansprüche 2 bis 13, **dadurch gekennzeichnet, dass** die Transportelemente Transportrollen sowie zumindest teilweise Niederhalter umfassen.
